# FASCICULE DE BREVET EUROPEEN

(11) **EP 2 392 689 B1**
(45) Date de publication et mention de la délivrance du brevet: **01.05.2013**
(21) Numéro de dépôt: 11168320.7
(22) Date de dépôt: 31.05.2011
(51) Int. Cl.: C23C 14/02, C23C 14/08, B44C 3/02, B44C 5/04, B44F 1/08

(54) **Article décoratif avec revêtement rouge et procédé**
Dekorationsartikel mit roter Beschichtung, und Verfahren
Decorative item with red covering and method

(30) Priorité: 04.06.2010 CH 8922010
(43) Date de publication de la demande: 07.12.2011
(73) Titulaire: Positive Coating SA, 2300 La Chaux-de-Fonds (CH)
(72) Inventeur: Jeanneret, Patrick, 2052 Fontainemelon (CH); Bisoffi, Fabrice, 25140 Charquemont (FR); Matthey, Joël, CH-2316 Les Ponts-de-Martel (CH); Meuterlos, Stéphane, 25500 Montlebon (FR); Steinmann, Pierre-Albert, 2325 Les Planchettes (CH)
(74) Mandataire: P&TS SA (AG, Ltd.)

(56) Documents cités:
- EP-A1- 0 430 874
- EP-A2- 0 708 154
- DE-A1-102006 035 688

## Description

### Domaine technique

La présente invention se rapporte à un article décoratif présentant une surface d'une couleur prédéterminée, par exemple rouge, obtenue, par exemple, par un procédé de dépôt physique en phase vapeur (PVD) tel que la pulvérisation cathodique. Des modes de réalisations de l'invention concernent des articles décoratifs avec une surface rouge pour la production de montres, instruments d'écriture, articles de maroquinerie, lunetterie, bijouterie ou décoration, ainsi qu'un procédé pour la fabrication de tels articles.

### Etat de la technique

L'industrie horlogère ou du domaine décoratif de manière plus générale est confrontée avec le problème de produire des articles décoratifs avec une variété d'aspects et couleurs attrayantes.

Les procédés de déposition physique, par exemple la pulvérisation cathodique, permettent d'obtenir des couches avec une apparence et des couleurs qui ne peuvent pas être réalisées avec des techniques de peinture ou émaillage conventionnelles. Ces couches sont également plus fines et présentent une grande durabilité, ce qui en permet l'emploi dans des éléments de petites tailles ou sujets à l'usure. On ne connaît pas, cependant, une technique de dépôt physique permettant d'obtenir des couches d'éclat métallique de couleur rouge.

Plusieurs substances naturelles doivent leur couleur rouge à l'oxyde ferrique (Fe₂O₃), telles les roches martiennes, le jaspe ou l'hématite. On sait déposer des couches d'oxyde ferrique sur une variété de substrats avec plusieurs techniques. Ces couches sont employées entre autres dans les mémoires magnétiques et présentent une couleur rouge-brunâtre assez terne et peu attrayante.

Dans la présente description, les propriétés colorimétriques du revêtement inventif sont exprimées à l'aide de l'espace colorimétrique CIE L*a*b* et mesurées selon le standard CIE 1976 (mode SCI; illuminant D65 - 10°).

### Bref résumé de l'invention

Un but de la présente invention est de proposer un procédé de déposition d'une couche rouge exempt des limitations des procédés connus, ainsi qu'un article décoratif avec une surface revêtue d'une couche fine de couleur rouge obtenue par un tel procédé.

Selon l'invention, ces buts sont atteints notamment au moyen de l'article et du procédé qui sont l'objet des revendications indépendantes dans les catégories correspondantes.

Cette solution présente notamment l'avantage par rapport à l'art antérieur de permettre l'obtention de couleurs très vives sur une grande variété de substrats.

### Brève description des figures

Des exemples de mise en oeuvre de l'invention sont indiqués dans la description illustrée par les figures annexées dans lesquelles :
- Les figures 1a et 1b illustrent schématiquement et en coupe une source de pulvérisation cathodique de type traditionnelle et une source adaptée selon un aspect du procédé inventif.
- Les figures 2a - 2c illustrent schématiquement la structure de la surface d'un article décoratif selon l'invention.
- La figure 3 montre de façon simplifiée le spectre d'absorption d'une couche de Fe₂O₃ et d'une surface pour un article décoratif selon un aspect de l'invention.
- La figure 4 illustre les paramètres colorimétriques d'un revêtement selon l'invention.

### Exemple(s) de mode de réalisation de l'invention

Selon un aspect de l'invention, la déposition des couches fines conférant une couleur rouge à la surface de l'article décoratif a été effectuée par un procédé PVD de pulvérisation cathodique magnétron. On comprend toutefois que les mêmes couches pourraient également être déposées, dans le cadre de l'invention, par une autre méthode de dépôt physique appropriée.

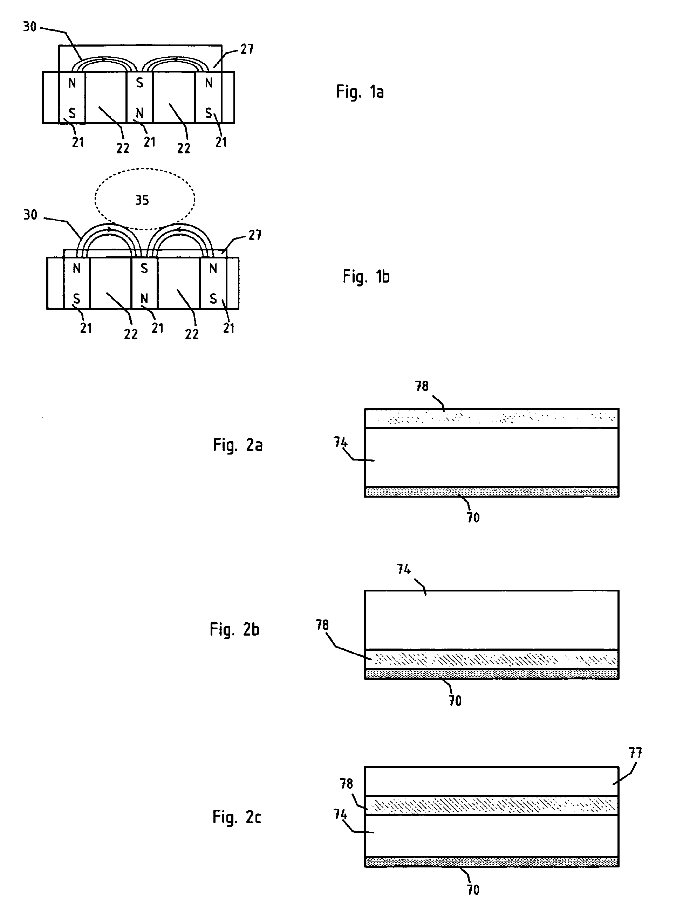

La figure 1a représente une source de pulvérisation de type magnétron comprenant un arrangement d'aimants 21, des canaux de refroidissement 22 et une cible de pulvérisation 27. Le fonctionnement de ces dispositifs de pulvérisation est décrit dans la littérature scientifique et technique, et il ne sera répété ici que dans les grandes lignes.

La pulvérisation cathodique magnétron consiste à pulvériser une cible constituée d'un matériau à déposer par un plasma, par exemple d'Argon, à l'intérieur d'une enceinte contenant un gaz à faible pression. Un champ électrique accélère alors les ions du plasma en direction de la cible. Des aimants situés derrière la cible permettent le confinement des électrons du plasma, ceux-ci s'enroulant autour des lignes de champ créées par les aimants. Le champ électrique créé par l'alimentation de la cible (continue, radio fréquence ou pulsée) apporte aux électrons l'énergie nécessaire à l'ionisation du gaz de l'enceinte. Un plasma intense est alors généré à l'intérieur de l'enceinte.

Le bombardement de la cible par les ions du plasma provoque la pulvérisation (sputtering) des atomes de la cible qui se condensent sur le substrat. La pulvérisation peut s'effectuer en conditions inertes (typiquement en une atmosphère d'Argon pur). On peut aussi fabriquer des films d'oxydes ou d'autres composés chimiques avec la pulvérisation réactive, dans laquelle un gaz réactif tel qu'O₂ ou N₂ est ajouté à l'atmosphère inerte de l'enceinte.

Lorsqu'on souhaite déposer des couches d'oxyde de fer, on peut utiliser une cible 27 de fer métallique, par exemple. En ce cas le champ magnétique généré par les aimants est déformé par le ferromagnétisme de la cible 27 et les lignes de champ magnétique 30 se ferment essentiellement à l'intérieur de la cible 27. Dans ces conditions il n'y a pas de production de plasma et la source de pulvérisation est inefficace.

Des essais ont permis de surmonter cette difficulté en adoptant, comme le montre la figure 1b, une cible de fer 27 plus mince et en augmentant l'intensité magnétique générée par les aimants 21. Dans cette situation les lignes du champ magnétique 30 sortent de la cible 27 et un plasma intense se forme dans la région 35. La pulvérisation de la cible est alors possible.

Sans vouloir être limité par la théorie, on peut imaginer que l'adoption d'une cible 27 mince et d'une valeur élevée du champ magnétique provoque, dans la disposition de la figure 1b, la saturation d'au moins une partie de la cible 27, réduisant ainsi sa perméabilité magnétique effective, et permettant ainsi d'étendre le champ magnétique à la région 35. D'autres arrangements de source magnétron permettant de pulvériser des matériaux à haute perméabilité magnétique sont possibles et compris dans le cadre de la présente invention. On pourrait également envisager d'employer des sources de pulvérisation d'autre nature, par exemple des sources de pulvérisation à faisceau ionique, ou tout autre procédé de déposition PVD ou CVD approprié.

La disposition de la source de la figure 1b combinée à une atmosphère réactive contenant de l'oxygène, permet la déposition de couches de couleur rouge avec une bonne adhérence sur de nombreux substrats. On fabrique typiquement des couches dont l'épaisseur est de l'ordre du micromètre, par exemple entre 750 nm et 1500 nm. Les couches ainsi obtenues sont semi-transparentes : elles absorbent sélectivement les UV et la lumière à faible longueur d'onde, et sont transparentes pour les radiations visibles à grande longueur d'onde et pour l'IR. Des analyses par XPS et par spectroscopie Raman ont montré que la composition chimique de la couche absorbante ainsi obtenue est de l'oxyde ferrique Fe₂O₃, ou hématite. En réduisant la proportion d'oxygène dans l'atmosphère réactive on peut obtenir des couches d'une couleur plus sombre, probablement imputable à la déposition de magnétite (Fe₃O₄) et/ou de fer métallique.

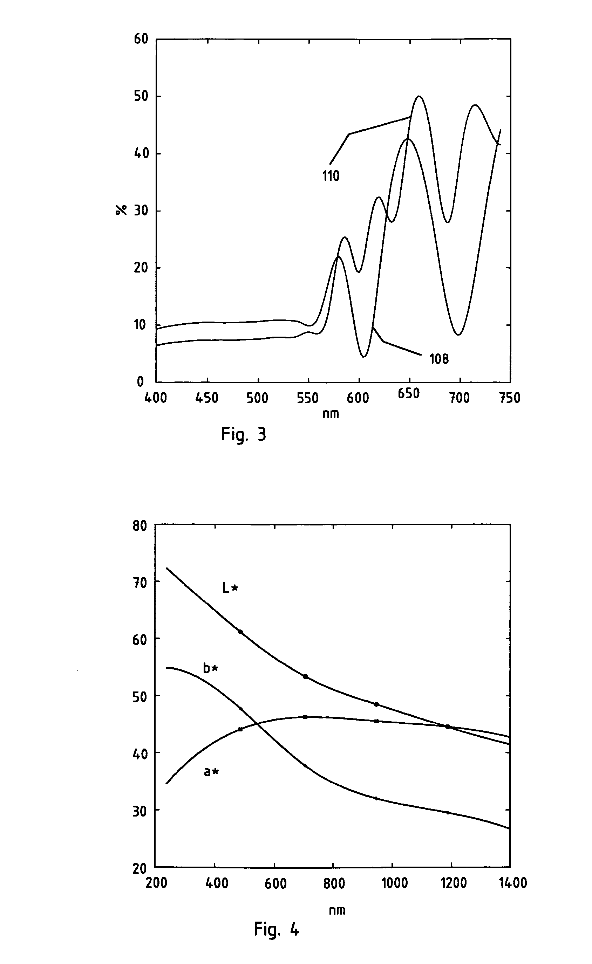

Afin d'obtenir un article décoratif avec une surface ayant une couleur rouge, une couche absorbante de Fe₂O₃ peut être déposée directement sur une surface réfléchissante, par exemple une surface métallique d'Al ou Ag. On obtient de cette façon une couche brune rougeâtre, mais pas une couleur véritablement rouge. Concrètement les surfaces ainsi obtenues présentaient, dans un cas typique d'une couche de Fe₂O₃ de 740 nm d'épaisseur déposée sur un substrat d'acier inox poli, une couleur, exprimée par L*=43.52, a*=13.03, b*=8.62 dans le système CIE. La réflectance d'une telle couche est représentée en fonction de la longueur d'onde de la lumière incidente par la courbe 108 de la figure 3. On observe une succession de maxima et minima dans la courbe de réflectance. Sans vouloir être limité par la théorie, on interprète ces oscillations comme le résultat d'un phénomène d'interférence optique entre les rayons réfléchis par les surfaces inférieure et supérieure de la lame mince de Fe₂O₃.

La figure 2a représente schématiquement une structure de couches qui permet de réduire sensiblement les oscillations dans la réflectance. Une sous-couche transparente 74 est interposée entre la couche réfléchissante 70 et la couche absorbante de Fe₂O₃ 78. Dans un cas typique, la couche 78 était une couche de Fe₂O₃ de 740 nm d'épaisseur déposée sur une couche transparente 74 de Al₂O₃ de 1,5 micromètres, sur une couche réfléchissante d'acier 70. La réflectance d'un tel revêtement est illustrée par la courbe 110 de la figure 3, dans laquelle on peut constater des oscillations sensiblement réduites et rapprochées par rapport à celles de la courbe 108. La couche transparente 74 éclaircit la couleur du revêtement décoratif. Des essais ont montré que dans des conditions de déposition typiques on peut obtenir des revêtements décoratifs de couleur rouge caractérisés par des valeurs du paramètre a* supérieures à 30, par exemple 32, 35 ou plus.

Sans limitation pour la portée de l'invention, on considère que la couche transparente 74 et la couche absorbante de Fe₂O₃ 78 présentent des index de réfraction assez similaires et peuvent être considérés comme une seule lame d'épaisseur plus élevée, ce qui comporte un rapprochement et un filtrage des maxima d'interférence, comme le montre la figure 3. L'effet éclaircissant de la couche transparente 74 est modifié aussi par son épaisseur, sa composition chimique et son homogénéité. Des essais ont montré qu'un effet éclaircissant notable est présent pour des couches de 200 nm d'épaisseur, préférablement des couches d'épaisseur supérieure à 500 nm, plus préférablement des couches de plus de 1000 nm d'épaisseur.

Selon une variante préférée du procédé inventif, la couche réfléchissante 70 et la couche transparente 74 sont également déposées par PVD, par exemple à partir d'une cible de pulvérisation cathodique d'aluminium utilisée d'abord en atmosphère inerte pour déposer une couche réfléchissante 70 d'aluminium métallique, et ensuite en atmosphère réactive contenant de l'oxygène pour fabriquer une couche transparente 74 de Al₂O₃. De cette manière une seule installation PVD peut être utilisée pour fabriquer la structure de la figure 2a à partir de deux sources magnétron de fer et d'aluminium sur n'importe quel substrat idoine, pour obtenir un article décoratif de couleur rouge. Dans une autre variante, on pourrait aussi déposer la couche réfléchissante 70 et la couche absorbante 78 de part et d'autre d'un substrat transparent 74, par exemple de part et d'autre d'une lame de verre, de quartz ou de saphir.

Sans être limité par l'exemple précédent, la présente invention inclut des couches transparentes 74 réalisées avec n'importe quel matériau transparent. Notamment, on pourrait déposer une couche transparente de n'importe quel oxyde ou nitrure transparent, par exemple SiO₂, In₂O₃, SnO₂, oxyde d'indium dopé à l'étain (ITO, In₂O₃: Sn), AlN, Si₃N₄, Ta₂O₅, TiO₂, ZrO₂, WO₃, ou de carbone amorphe DLC (Diamond-Like Carbon). Comme mentionné plus haut, les couches 74 et/ou 78 peuvent être fabriquées avec n'importe quel procédé de dépôt physique, par exemple évaporation, pulvérisation par faisceau d'ions, placage ionique (ion plating), arc cathodique ou arc cathodique filtré.

L'invention pourrait aussi prévoir la déposition de couches supplémentaires, par exemple des couches d'accrochage sous la couche réfléchissante 70 et/ou des couches de protection anti-usure transparentes sur la couche absorbante de Fe₂O₃ 78. Par ailleurs l'interface entre la couche réfléchissante 70 et la couche transparente 74 pourrait être dépolie et réfléchir la lumière incidente de manière diffuse au lieu d'être spéculaire; on pourrait également remplacer la couche réfléchissante spéculaire par une couche réfléchissante diffusive blanche déposée, peinte ou appliquée. Le procédé inventif pourrait aussi inclure des étapes de nettoyage des substrats par décapage ionique.

La couche transparente 74 améliore la couleur du revêtement aussi lorsqu'elle est déposée au dessus de la couche absorbante 78, comme représenté à la *figure 3b* qui montre une disposition de couches pour obtenir un revêtement rouge selon une variante de l'invention. La structure des figures 2a et/ou 2b pourrait aussi, selon une variante non représentée de l'invention, être répliquée deux ou plusieurs fois en superposition, par exemple sous forme d'une alternance de couches absorbantes et transparentes. La Figure 2c montre un exemple de structure avec deux couches transparentes 74 et 77 disposées de part et d'autre de la couche absorbante 78. Dans ce cas la couche supérieure 77 a également une fonction de protection anti-usure. Préférablement, elle est réalisée avec un matériau dur et particulièrement résistent à l'usure, par exemple le carbone amorphe DLC déposé avec une source d'arc cathodique ou arc cathodique filtré.

Les couches qui font l'objet de l'invention peuvent être déposées aussi par des procédés différents du dépôt physique en phase vapeur (PVD). La couche supérieure 77, notamment, peut être une couche vitreuse obtenue par un procédé sol-gel, ou un film organique de protection, par exemple un film de résine époxy, une couche transparente de laque ou de vernis, ou tout autre couche ayant des caractéristiques de transparence et résistance à l'usure appropriées.

Selon une autre variante de l'invention, la couche 74 est une couche semi-transparente absorbant une partie du spectre lumineux et contribuant au couleur résultant du revêtement.

La figure 4 illustre les propriétés colorimétriques d'un exemple de revêtement selon l'invention en fonction de l'épaisseur de la couche absorbante de Fe₂O₃ 78, déposé sur un côté d'une lame de saphir transparent sur un fond réfléchissant blanc.

Le procédé de l'invention permet de déposer un revêtement rouge sur divers éléments, afin d'obtenir des articles décoratifs particulièrement attrayants et d'un bel effet. On peut par exemple déposer un revêtement rouge par le procédé inventif sur des éléments de montres, notamment des composants d'habillage interne tels que cadrans, vis, aiguilles, index, ponts, platines, barillets, ou sur des éléments externes, par exemple boîtes, lunettes, fonds, couronnes, boutons poussoirs, maillons ou fermoirs de bracelet. Par ailleurs le procédé de l'invention peut être appliqué également à d'autres articles décoratifs, par exemple des fermoirs, boucles, des bagues, des bracelets, ou tout autre article de maroquinerie et/ou de bijouterie, ainsi qu'à des lunettes ou à des instruments d'écriture.

### Numéros de référence employés sur les figures

- 21: aimant
- 22: canal de refroidissement
- 27: cible de Fe
- 30: lignes de champ magnétique
- 35: plasma
- 70: couche réfléchissante
- 74: couche transparente
- 78: couche absorbante de Fe₂O₃
- 108: réflectivité sans couche transparente
- 110: réflectivité avec couche transparente

## Revendications

1. Article décoratif ayant une surface et comprenant une couche réfléchissante (70) sur laquelle sont superposées au moins une couche transparente ou semi-transparente (74) et une couche absorbante de Fe₂O₃ (78) donnant à la dite surface une couleur prédéterminée.

2. Article décoratif selon la revendication précédente, dans lequel ladite couche transparente ou semi-transparente (74) a une épaisseur d'au moins 200 nm, préférablement au moins 500 nm, plus préférablement au moins 1000 nm.

3. Article décoratif selon l'une des revendications précédentes, dans lequel ladite surface présente une couleur rouge avec une valeur du paramètre a* mesurée selon le standard CIE 1976 en mode SCI, illuminant D65-10°, supérieure à 30, préférablement supérieure à 32, plus préférablement supérieure à 35.

4. Article décoratif selon l'une des revendications précédentes, dans lequel ladite couche transparente ou semi-transparente (74) est interposée entre ladite couche réfléchissante (70) et ladite couche absorbante de Fe₂O₃.

5. Article décoratif selon l'une des revendications précédentes, comportant au moins une couche transparente ou semi-transparente (74, 77) au dessus de ladite couche absorbante de Fe₂O₃.

6. Article décoratif selon l'une des revendications précédentes, dans lequel au moins une parmi lesdites couches transparentes ou semi-transparentes (74, 77), réfléchissantes (70), et absorbantes (78) sont déposées par un procédé de dépôt physique en phase vapeur (PVD) parmi : pulvérisation cathodique, évaporation, pulvérisation par faisceau d'ions, placage ionique, arc cathodique, arc cathodique filtré ou par un procédé sol-gel.

7. Article décoratif selon l'une des revendications précédentes, dans lequel ladite couche transparente ou semi-transparente (74) présente une des compositions suivantes : Al₂O₃, SiO₂, In₂O₃, SnO₂, oxyde d'indium dopé à l'étain (ITO, In₂O₃: Sn), AIN, Si₃N₄,Ta₂O₅, TiO₂, ZrO₂, WO₃, carbone amorphe DLC (Diamond-Like Carbon).

8. Article décoratif selon l'une des revendications précédentes, étant un élément d'une montre.

9. Procédé de déposition d'un revêtement de couleur prédéterminée pour un article décoratif, comprenant des étapes de :
dépôt d'une couche réfléchissante (70) ;
dépôt d'une couche absorbante de Fe₂O₃ (78) ;
dépôt d'une couche transparente ou semi-transparente (74)

10. Procédé selon la revendication précédente, dans lequel ladite couche transparente ou semi-transparente (74) a une épaisseur d'au moins 200 nm, préférablement au moins 500 nm, plus préférablement au moins 1000 nm.

11. Procédé selon l'une des revendications de 9 à 10, dans lequel ladite couche transparente ou semi-transparente (74) est déposée entre ladite couche réfléchissante (70) et ladite couche absorbante de Fe₂O₃.

12. Procédé selon l'une des revendications de 9 à 11, dans lequel au moins une couche transparente ou semi-transparente (74, 77) est déposée au dessus de ladite couche absorbante de Fe₂O₃.

13. Procédé selon l'une des revendications de 9 à 12, dans lequel au moins une parmi lesdites couches transparente ou semi-transparente (74, 77), réfléchissante (70), et absorbante (78) sont déposées par un procédé de dépôt physique en phase vapeur (PVD) ou par un procédé sol-gel.

14. Procédé selon la revendication précédente, dans lequel ledit procédé de dépôt physique en phase vapeur est un procédé parmi : pulvérisation cathodique, évaporation, pulvérisation par faisceau d'ions, placage ionique, arc cathodique, arc cathodique filtré.

15. Procédé selon l'une des revendications de 9 à 14, dans lequel ladite couche transparente ou semi-transparente (74) ) présente une des compositions suivantes : Al₂O₃, SiO₂, In₂O₃, SnO₂, oxyde d'indium dopé à l'étain (ITO, In₂O₃: Sn), AIN, Si₃N₄, Ta₂O₅, TiO₂, ZrO₂, WO₃, carbone amorphe DLC (Diamond-Like Carbon).

## Claims

1. Decorative article having a surface and comprising a reflective layer (70) on which are superposed at least one transparent or semi-transparent layer (74) and an absorbing layer of Fe₂O₃ (78) conferring a determined colour to said surface.

2. Decorative article according to the preceding claim, wherein said transparent or semi-transparent layer (74) has a thickness of at least 200 nm, preferably at least 500 nm, more preferably at least1000 nm.

3. Decorative article according to any of the preceding claims, wherein said surface has a red colour with a value of parameter a*, measured according to the CIE 1976 SCI mode standard illumination D65-10°, higher than 30, preferably higher than 32, more preferably higher than 35.

4. Decorative article according to any of the preceding claims, wherein said transparent or semi-transparent layer (74) is interposed between said reflective layer (70) and said absorbing layer of Fe₂O₃.

5. Decorative article according to any of the preceding claims, having at least one transparent or semi-transparent layer (74, 77) above said absorbing layer of Fe₂O₃.

6. Decorative article according to any of the preceding claims, wherein at least one of said transparent or semi-transparent (74, 77), reflective (70), and absorbing (78) layers are deposited by means a Physical Vapour Deposition process (PVD) from: cathode sputtering, evaporation, ion-beam sputtering, ion plating, cathodic arc deposition, filtered cathodic arc deposition; or by a sol-gel process.

7. Decorative article according to any of the preceding claims, wherein said transparent or semi-transparent layer (74) has one of the following compositions: Al₂O₃, SiO₂, In₂O₃, SnO₂, Indium Tin oxide (ITO, In₂O₃: Sn), AIN, Si₃N₄,Ta₂O₅, TiO₂, ZrO₂, WO₃, amorphous carbon, DLC (Diamond-Like Carbon).

8. Decorative article according to any of the preceding claims, being an element of a watch.

9. Method of deposition of a layer having a determined colour for a decorative article with the steps of:
deposition of a reflective layer (70) ;
deposition of an absorbing layer of Fe₂O₃ (78) ;
deposition of a transparent or semi-transparent layer (74).

10. Method according to the preceding claim, wherein said transparent or semi-transparent layer (74) has a thickness of at least 200 nm, preferably at least 500 nm, more preferably at least1000 nm.

11. Method according to any of the claims from 9 to 10, wherein said transparent or semi-transparent layer (74) is deposited between said reflective layer (70) and said absorbing layer of Fe₂O₃.

12. Method according to any of the claims from 9 to 11, wherein at least one transparent or semi-transparent layer (74, 77) is deposited above said absorbing layer of Fe₂O₃.

13. Method according to any of the claims from 9 to 12, wherein at least one of said transparent or semi-transparent (74, 77), reflective (70), and absorbing (78) layers are deposited by means a Physical Vapour Deposition process (PVD) or by a sol-gel process.

14. Method according to the preceding claim, wherein said Physical Vapour Depositon process is a process from: cathode sputtering, evaporation, ion-beam sputtering, ion plating, cathodic arc deposition, filtered cathodic arc deposition.

15. Method according to any of the claims from 9 to 14, wherein said transparent or semi-transparent layer (74) has one of the following compositions: Al₂O₃, SiO₂, In₂O₃, SnO₂, Indium Tin oxide (ITO, In₂O₃: Sn), AIN, Si₃N₄,Ta₂O₅, TiO₂, ZrO₂, WO₃, amorphous carbon, DLC (Diamond-Like Carbon).

## Patentansprüche

1. Dekorativer Artikel aufweisend eine Oberfläche und aufweisend eine reflektierende Schicht (70), über der mindestens eine transparente oder halb-transparente Schicht (74) und eine absorbierende Schicht aus Fe₂O₃ (78), die der Oberfläche eine bestimmte Farbe verleiht, angeordnet ist.

2. Dekorativer Artikel nach dem vorhergehenden Anspruch, wobei die transparente oder halb-transparente Schicht (74) eine Dicke von mindestens 200 nm, bevorzugterweise mindestens 500 nm, noch bevorzugter mindestens 1000 nm aufweist.

3. Dekorativer Artikel nach einem der vorhergehenden Ansprüche, wobei die Oberfläche eine rote Farbe mit einem nach dem CIE 1976 SCI Beleuchtungsartstandard D65-10° gemessenen Wert des Parameters A* grösser als 30, bevorzugterweise grösser als 32, noch bevorzugter grösser als 35 aufweist.

4. Dekorativer Artikel nach einem der vorhergehenden Ansprüche, wobei die transparente oder halb-transparente Schicht (74) zwischen der reflektierenden Schicht (70) und der absorbierenden Schicht des Fe₂O₃ angeordnet ist.

5. Dekorativer Artikel nach einem der vorhergehenden Ansprüche aufweisend mindestens eine transparente oder halb-transparente Schicht (74, 77) über der absorbierenden Schicht des Fe₂O₃.

6. Dekorativer Artikel nach einem der vorhergehenden Ansprüche, wobei mindestens eine der transparenten oder halb-transparenten (74, 77), reflektierenden (70), und absorbierenden (78) Schicht durch Mittel einer physikalischen Gasphasenabscheidung, z.B. Kathodenzerstäubung, thermisches Verdampfen, Ionenstrahlsputtern, Ionenplattieren, Lichtbogenverdampfen, gefiltertes Lichtbogenverdampfen; oder durch ein Sol-Gel Verfahren aufgetragen werden.

7. Dekorativer Artikel nach einem der vorhergehenden Ansprüche, wobei die transparente oder halb-transparente Schicht (74) eine der folgenden Zusammensetzungen hat: Al₂O₃, SiO₂, In₂O₃, SnO₂, Indiumzinnoxid (ITO, In₂O₃: Sn), AIN, Si₃N₄,Ta₂O₅, TiO₂, ZrO₂, WO₃, amorpher Kohlenstoff, DLC (Diamant-ähnlicher Kohlenstoff).

8. Dekorativer Artikel nach einem der vorhergehenden Ansprüche, der ein Teil einer Uhr ist.

9. Verfahren zum Auftragen einer Schicht, die eine bestimmte Farbe aufweist, für einen dekorativen Artikel mit den Schritten:
Auftragen einer reflektierenden Schicht (70);
Auftragen einer absorbierenden Schicht von Fe₂O₃ (78);
Auftragen einer transparenten oder halb-transparenten Schicht (74).

10. Verfahren nach dem vorhergehenden Anspruch, wobei die transparente oder halb-transparente Schicht (74) eine Dicke von mindestens 200 nm, bevorzugterweise mindestens 500 nm, noch bevorzugter mindestens 1000 nm aufweist.

11. Verfahren nach einem der Ansprüche 9 bis 10, wobei die transparente oder halb-transparente Schicht (74) zwischen der reflektierenden Schicht (70) und der absorbierenden Schicht des Fe₂O₃ angeordnet ist.

12. Verfahren nach einem der Ansprüche 9 bis 11, wobei mindestens eine transparente oder halb-transparente Schicht (74, 77) über der absorbierenden Schicht des Fe₂O₃.

13. Verfahren nach einem der Ansprüche 9 bis 12, wobei mindestens eine der transparenten oder halb-transparenten (74, 77), reflektierenden (70), und absorbierenden (78) Schicht durch Mittel einer physikalischen Gasphasenabscheidung oder durch ein Sol-Gel Verfahren aufgetragen wird

14. Verfahren nach dem vorhergehenden Anspruch, wobei das physikalischen Dampfbeschichtungsverfahrens ein Verfahren von den folgenden ist: Kathodenzerstäubung, thermisches Verdampfen, lonenstrahlsputtern, Ionenplattieren, Lichtbogenverdampfen, gefiltertes Lichtbogenverdampfen.

15. Verfahren nach einem der Ansprüche 9 bis 14, wobei die transparente oder halb-transparente Schicht (74) eine der folgenden Zusammensetzungen hat: Al₂O₃, SiO₂, In₂O₃, SnO₂, Indiumzinnoxid (ITO, In₂O₃: Sn), AIN, Si₃N₄,Ta₂O₅, TiO₂, ZrO₂, WO₃, amorpher Kohlenstoff, DLC (Diamant-ähnlicher Kohlenstoff).
